# EUROPEAN PATENT APPLICATION

(11) **EP 4 704 529 A1**
(43) Date of publication of application: **04.03.2026**
(21) Application number: 25192210.0
(22) Date of filing: 28.07.2025
(51) Int. Cl.: H10H 29/30, H10H 29/85

(54) **DISPLAY DEVICE**

(30) Priority: 27.08.2024 CN 202411185926
(71) Applicant: InnoLux Corporation, Jhunan Town Miao li 35053 (TW)
(72) Inventor: LIU, Pei-Hsien, 35053 Jhunan Town, Miaoli County (TW); HSIEH, Chi-Han, 35053 Jhunan Town, Miaoli County (TW); KUO, Chiung-Chieh, 35053 Jhunan Town, Miaoli County (TW); KUO, Kuan-Hung, 35053 Jhunan Town, Miaoli County (TW)
(74) Representative: Becker, Eberhard

(57) **Abstract**

A display device (1) includes a circuit substrate (10), a pixel definition layer (11), a light-emitting chip (12), and an underfill layer (13). The pixel definition layer (11) is disposed on the circuit substrate (10) and includes an aperture (A11). The light-emitting chip (12) is disposed in the aperture (A11) and electrically connected to the circuit substrate (10). The light-emitting chip includes (12) a light-emitting diode (120), a filling layer (121), and a reflective layer (122). The filling layer (121) surrounds the light-emitting diode (120). The reflective layer (122) is disposed on a side surface (S121) of the filling layer (121). The underfill layer (13) is disposed between the light-emitting chip (12) and the pixel definition layer (11).

## Description

### BACKGROUND

### Technical Field

This disclosure relates to an electronic device, and in particular to a display device.

### Description of Related Art

The development of display devices using light-emitting diodes as pixels has become quite mature, but there are still some issues that need to be improved, such as the size of the light-emitting chip, luminous efficiency, complexity of the transfer process, transfer efficiency, cost, and/or color performance.

### SUMMARY

The disclosure provides a display device that helps improve at least one of the above problems.

In an embodiment of the disclosure, the display device includes a circuit substrate, a pixel definition layer, a light-emitting chip, and an underfill layer. The pixel definition layer is disposed on the circuit substrate and includes an aperture. The light-emitting chip is disposed in the aperture and electrically connected to the circuit substrate. The light-emitting chip includes a light-emitting diode, a filling layer, and a reflective layer. The filling layer surrounds the light-emitting diode. The reflective layer is disposed on a side surface of the filling layer. The underfill layer is disposed between the light-emitting chip and the pixel definition layer.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate example embodiments of the disclosure and, together with the description, serve to explain the principles of the disclosure.
FIG. 1A, FIG. 2, FIG. 3, and FIG. 4 are partial cross-sectional schematic diagrams of four display devices according to some embodiments of the disclosure.
FIG. 1B is an enlarged schematic diagram of a light-emitting chip in FIG. 1A.
FIG. 5 to FIG. 9 are cross-sectional schematic diagrams of manufacturing and transfer processes of light-emitting chips.

### DESCRIPTION OF THE EMBODIMENTS

Reference will now be made in detail to the exemplary embodiments of the disclosure, examples of which are illustrated in the accompanying drawings. Whenever possible, the same reference numerals are used in the drawings and descriptions to refer to the same or similar parts.

Throughout this specification and the claims, certain words are used to refer to specific components. One of ordinary skill in the art will appreciate that manufacturers of electronic devices may refer to the same component by different names. This disclosure is not intended to differentiate between components that have the same function but have different names. In the following description and claims, the words "include" and "comprise" are open-ended terms and should therefore be interpreted to mean "includes, but is not limited to...".

The directional terms mentioned in this disclosure, such as "up", "down", "front", "back", "left", "right", etc., are only for reference to the directions in the accompanying drawings. Accordingly, the directional terms used are illustrative and not limiting of the disclosure. In the drawings, each figure illustrates the general features of methods, structures, and/or materials used in particular embodiments. However, these drawings should not be interpreted as defining or limiting the scope or nature encompassed by these embodiments. For example, the relative sizes, thicknesses, and locations of various layers, regions, and/or structures may be reduced or exaggerated for clarity.

One structure (or layer, component, substrate) described in the disclosure is located on/above another structure (or layer, component, substrate), which may mean that the two structures are adjacent to each other and are directly connected, or that the two structures are adjacent to each other and are not directly connected. Non-directly connected means that there is at least one intermediary structure (or intermediary layer, intermediary component, intermediary substrate, intermediary spacer) between the two structures, with the lower surface of one structure adjacent to or directly connected to the upper surface of the intermediary structure, and the upper surface of the other structure adjacent to or directly connected to the lower surface of the intermediary structure. The intermediary structure may be a single or multi-layered solid or non-solid structure, without limitation. In the disclosure, when a structure is disposed "on" other structures, it may mean that a structure is "directly" on the other structures, or that a structure is "indirectly" on the other structures, that is, a structure and other structures have at least one other structure sandwiched between them.

The terms "approximately", "substantially" or "generally" are generally interpreted as being within 10% of the given value or range, or within 5%, 3%, 2%, 1% or 0.5% of the given value or range. In addition, the terms "the range is from the first value to the second value", "the range is between the first value and the second value" indicate that the range includes the first value, the second value, and other values in between.

The ordinal numbers used in the specification and claims, such as "first" and "second", are used to qualify the components, and do not in themselves imply or represent any previous ordinal number of the component or components, nor do they represent the order of one component or component with another, or the order of the manufacturing method. The use of these numbers is intended only to enable a component with a certain designation to be clearly distinguished from another component with the same designation. The same terminology may not be used in the claims and the specification. Accordingly, the first component in the specification may be the second component in the claims.

The electrical connection or coupling described in the disclosure may refer to either a direct connection or an indirect connection, in which the terminals of the two circuit elements are directly connected or connected to each other by a conductor line, or an indirect connection in which the terminals of the two circuit elements are connected by a switch, a diode, a capacitor, an inductor, a resistor, or any other suitable component, or a combination of the foregoing, without limitation.

In this disclosure, the thickness, length, and width can be measured by using an optical microscope (OM), and the thickness or width can be measured by cross-sectional images in an electron microscope, but is not limited thereto. In addition, there may be a certain amount of error between any two values or directions used for comparison. Furthermore, the expression "the given range is the first value to the second value", "the given range falls within the range of the first value to the second value" or "the given range is between the first value to the second value" means that the given range includes the first value, the second value, and other values in between. If the first direction is perpendicular to the second direction, the angle between the first direction and the second direction can be between 80 degrees and 100 degrees; if the first direction is parallel to the second direction, the angle between the first direction and the second direction can be between 0 degrees and 10 degrees.

Unless otherwise defined, all terms used herein, including technical and scientific terms, have the same meanings as are commonly understood by those skilled in the art. It is to be understood that these terms, such as those defined in commonly used dictionaries, should be interpreted as having a meaning consistent with the context or background of the relevant technology and the present disclosure, and should not be interpreted in an idealized or overly formalized manner, except as specifically defined in the embodiments of the present disclosure.

In the disclosure, the electronic device may include a display device, a backlight device, an antenna device, a packaging device, a sensing device, or a splicing device, but is not limited thereto. The electronic device may be a bendable or flexible electronic device. The display device can be a non-self-illuminating display device or a self-illuminating display device. The display device may include, for example, liquid crystal, light-emitting diode, fluorescence, phosphor, quantum dot (QD), other suitable display media, or a combination of the above. The antenna device may include, for example, a reconfigurable intelligent surface (RIS), a frequency selective surface (FSS), a radio frequency filter (RF-Filter), a polarizer, a resonator, or an antenna. (Antenna) et al. The antenna may be a liquid crystal antenna or a varactor diode antenna. The sensing device may be a sensing device that senses capacitance, light, heat energy, or ultrasonic waves, but is not limited thereto. In the disclosure, the electronic device may include electronic components, and the electronic components may include passive components and active components, such as capacitors, resistors, inductors, diodes, transistors. Diodes may include light-emitting diodes, varactor diodes, or photodiodes. The light-emitting diode may include, for example, an organic light-emitting diode (OLED), a sub-millimeter light-emitting diode (mini-LED), a micro light-emitting diode (micro-LED), or a quantum dot light-emitting diode (quantum dot LED), but not limited thereto. The splicing device may be, for example, a display splicing device or an antenna splicing device, but is not limited thereto. It should be noted that the electronic device can be any combination of the above, but is not limited thereto. The packaging device may be suitable for Wafer-Level Package (WLP) technology or Panel-Level Package (PLP) technology, such as chip first or RDL first process. In addition, the shape of the electronic device may be a rectangular shape, a circular shape, a polygonal shape, a shape with curved edges, or other suitable shapes. Electronic devices may have peripheral systems such as drive systems, control systems, and light source systems to support display devices, antenna devices, wearable devices (e.g., including augmented reality or virtual reality), vehicle-mounted devices (e.g., including car windshields), or splicing devices.

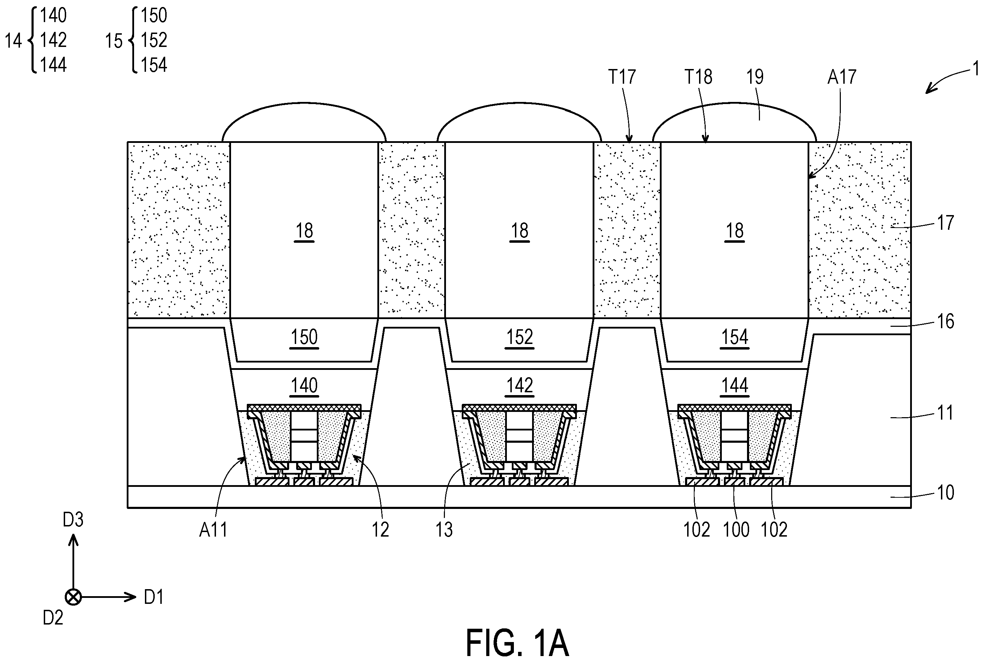

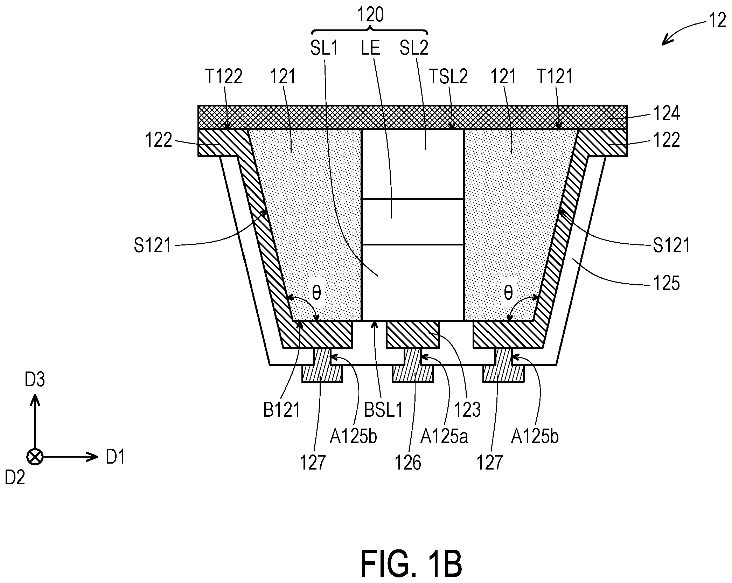

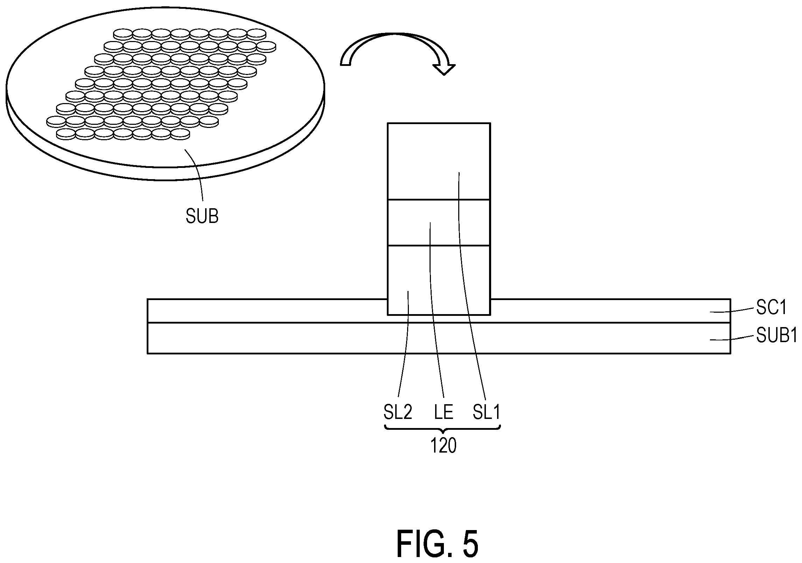

FIG. 1A, FIG. 2, FIG. 3, and FIG. 4 are partial cross-sectional schematic diagrams of four display devices according to some embodiments of the disclosure. FIG. 1B is an enlarged schematic diagram of a light-emitting chip in FIG. 1A. FIG. 5 to FIG. 9 are cross-sectional schematic diagrams of manufacturing and transfer processes of light-emitting chips. It should be noted that the following embodiments can be replaced, reorganized, and mixed with features of several different embodiments without departing from the spirit of the disclosure to complete other embodiments. Features in various embodiments may be mixed and matched as long as they do not violate the spirit of the invention or conflict with each other.

Please refer to FIG. 1A and FIG. 1B first. A display device 1 may include a circuit substrate 10, a pixel definition layer 11, a light-emitting chip 12, and an underfill layer 13. The pixel definition layer 11 is disposed on the circuit substrate 10 and includes an aperture A11. The light-emitting chip 12 is disposed in the aperture A11 and is electrically connected to the circuit substrate 10. The light-emitting chip 12 includes a light-emitting diode 120, a filling layer 121, and a reflective layer 122. The filling layer 121 surrounds the light-emitting diode 120. The reflective layer 122 is disposed on a side surface S121 of the filling layer 121. The underfill layer 13 is disposed between the light-emitting chip 12 and the pixel definition layer 11.

Specifically, the circuit substrate 10 may include a circuit board, a flexible circuit board, or a carrier board with a circuit formed thereon (e.g., a glass substrate or a plastic substrate), which is not limited thereto. The circuit substrate 10 may include multiple pads for electrically connecting to the light-emitting chip 12, such as a first pad 100 and a second pad 102. The first pad 100 and the second pad 102 are separated from each other to maintain independent electrical properties. In some embodiments, as shown in FIG. 1A, the second pad 102 may surround the first pad 100, but is not limited thereto. The materials of the pads include, for example, gold, tin, indium, copper, or other suitable conductive materials.

The aperture A11 of the pixel definition layer 11 defines a pixel region of display device 1, that is, the region where the light-emitting chip 12 is disposed. In some embodiments, as shown in FIG. 1A, the first pad 100 and the second pad 102 can be disposed together in the aperture A11, but is not limited thereto. In some embodiments, as shown in FIG. 1A, the pixel definition layer 11 may include multiple apertures A11 to accommodate multiple light-emitting chips 12 respectively. The apertures A11 can be arranged in an array in a direction D1 and a direction D2. The direction D1 and the direction D2 are both perpendicular to a thickness direction (e.g., a direction D3) of the display device 1. In addition, the direction D1 and the direction D2 intersect each other and are, for example, perpendicular to each other, but are not limited thereto.

The material of the pixel definition layer 11 includes, for example, organic photoresist. The color of the pixel definition layer 11 can be transparent, black, white, or other colors, but is not limited thereto. In some embodiments, although not shown, a reflective layer can be formed on the inner wall of the pixel definition layer 11 to improve luminous efficiency. Materials of the reflective layer include, for example, silver, aluminum, or other materials with high reflectivity (e.g., distributed Bragg reflector (DBR)).

The light-emitting diode 120 of the light-emitting chip 12 is used to provide light. Taking FIG. 1A as an example, the light-emitting diode 120 can be used to provide blue light, but is not limited thereto. The light-emitting diode 120 may include a first-type semiconductor layer SL1, a light-emitting layer LE, and a second-type semiconductor layer SL2 sequentially stacked in the direction D3. That is, the light-emitting layer LE is located between the first-type semiconductor layer SL1 and the second-type semiconductor layer SL2.

The first-type semiconductor layer SL1 and the second-type semiconductor layer SL2 may be a P-type semiconductor layer and an N-type semiconductor layer, respectively. Alternatively, the first-type semiconductor layer SL1 and the second-type semiconductor layer SL2 may be a N-type semiconductor layer and a P-type semiconductor layer, respectively. The light-emitting layer LE may include a quantum well layer or a multiple quantum well (MQW) layer, which may not be limited.

The filling layer 121 surrounds the light-emitting diode 120. For example, the filling layer 121 may contact at least the side surface of the light-emitting diode 120. For the sake of simplicity of the drawings, the side surface of the light-emitting diode 120 is not marked in FIG. 1A and FIG. 1B. The side surface of the light-emitting diode 120 includes, for example, the side surface of the first-type semiconductor layer SL1, the side surface of the light-emitting layer LE, and the side surface of the second-type semiconductor layer SL2.

The filling layer 121 can expose at least part of a bottom surface BSL1 of the first-type semiconductor layer SL1 to facilitate the electrical connection between the first-type semiconductor layer SL1 and a first electrode 123. In some embodiments, as shown in FIG. 1B, the filling layer 121 can expose the entire bottom surface BSL1 of the first-type semiconductor layer SL1, and a bottom surface B121 of the filling layer 121 can be flush with the bottom surface BSL1 of the first-type semiconductor layer SL1, but is not limited thereto.

The filling layer 121 can expose at least part of a top surface TSL2 of the second-type semiconductor layer SL2 to facilitate the electrical connection between the second-type semiconductor layer SL2 and a second electrode 124. In some embodiments, as shown in FIG. 1B, the top surface T121 of the filling layer 121 may be flush with the top surface TSL2 of the second-type semiconductor layer SL2, but is not limited thereto.

For example, the side surface S121 of the filling layer 121 is connected to a top surface T121 of the filling layer 121 and the bottom surface B121 of the filling layer 121, and the side surface S121 of the filling layer 121 is used to carry the reflective layer 122. In some embodiments, the cross-sectional shape of the filling layer 121 may be approximately an inverted trapezoid with a hollow center. In addition, the angle θ between the side surface S121 and the bottom surface B121 of the filling layer 121 is, for example, greater than or equal to 100 degrees and less than or equal to 170 degrees, or greater than or equal to 110 degrees and less than or equal to 150 degrees. By changing the angle θ, the inclination angle of the reflective layer 122 disposed on the side surface S121 of the filling layer 121 can be changed, thereby improving the light extraction efficiency, changing the light pattern or light intensity distribution, etc., of light emitted from the light-emitting chip 12.

The filling layer 121 may be made of a light-transmitting dielectric material to reduce the loss of light propagating in the filling layer 121. For example, the material of the filling layer 121 may include acrylic materials, siloxane materials, photoresist, silicone (Silica), or other material having a transmittance of visible light more than 80% or even 90% (e.g., light with a wavelength of 400 nm to 700 nm).

The reflective layer 122 is used to reflect light so that the light-emitting chip 12 can emit more light. The material of the reflective layer 122 includes, for example, silver, aluminum, tin, indium, gold, or combinations thereof, but is not limited thereto. In some embodiments, as shown in FIG. 1B, in addition to being disposed on the side surface S121 of the filling layer 121, the reflective layer 122 can further extend to the bottom surface B121 of the filling layer 121, and a terminal of the reflective layer 122 adjacent to the top surface T121 of the filling layer 121 may project in a direction (e.g., direction D1 and its opposite direction) away from the side surface S121 of the filling layer 121, but is not limited thereto.

In some embodiments, as shown in FIG. 1B, the light-emitting chip 12 may also include a first electrode 123, a second electrode 124, an insulating layer 125, a first contact pad 126, and a second contact pad 127, but is not limited thereto. According to different needs, the light-emitting chip 12 may be increased or decreased by one or more components or film layers.

The first electrode 123 is, for example, disposed on the bottom surface BSL1 of the first-type semiconductor layer SL1 and is electrically connected to the first-type semiconductor layer SL1. The first electrode 123 and the reflective layer 122 are separated from each other to maintain independent electrical properties. In some embodiments, the material of the first electrode 123 may include silver, aluminum, or other metals and/or alloys with high reflectivity, such as metals or alloys with a reflectivity higher than 60% for visible light, but is not limited thereto. In other embodiments, the material of the first electrode 123 may include gold, copper or other metals and/or alloys with high conductivity, and the inner side of the high conductivity metals and/or alloys (the side proximate to the light-emitting diode 120) may be formed with a non-conducting reflective layer, such as a distributed Bragg reflector, but is not limited thereby.

The second electrode 124 is, for example, disposed on the top surface TSL2 of the second-type semiconductor layer SL2 and is electrically connected to the second-type semiconductor layer SL2. In some embodiments, the second electrode 124 may be further disposed on the top surface T121 of the filling layer 121 and a top surface T122 of the reflective layer 122. Under this structure, the top surface T121 of the filling layer 121 and the top surface T122 of the reflective layer 122 can be flush with the top surface TSL2 of the second-type semiconductor layer SL2, so as to reduce the probability of disconnection of the second electrode 124 due to surface discontinuity. In addition, through the design that the terminal of the reflective layer 122 adjacent to the top surface T121 of the filling layer 121 protrudes in a direction away from the side surface S121 of the filling layer 121, a contact area between the second electrode 124 and the reflective layer 122 can be increased, which helps to reduce the contact resistance. The material of the second electrode 124 includes, for example, a transparent conductive material, so that light can pass through the second electrode 124. The transparent conductive material may include metal oxides, graphene, other suitable transparent conductive materials, or combinations thereof. Metal oxides may include indium tin oxide, indium zinc oxide, aluminum tin oxide, aluminum zinc oxide, indium germanium zinc oxide, or other metal oxides. In an embodiment where the material of the second electrode 124 includes a transparent conductive material, the second electrode 124 may also be referred to as a transparent conductive layer. Alternatively, the transparent conductive material may include a thin metal or metal mesh, for example, a very thin metal layer (e.g., magnesium layer or silver layer) may be formed, or a metal mesh layer with light-transmitting aperture that allows light to pass through the second electrode 124 may be formed by screen-printing or other patterning process.

The insulating layer 125 can cover the first electrode 123, the reflective layer 122, the light-emitting diode 120 and the filling layer 121 exposed by the first electrode 123 and the reflective layer 122. The material of the insulating layer 125 includes, for example, organic insulating materials, inorganic insulating materials, or combinations thereof. Examples of organic insulating materials include polymethylmethacrylate (PMMA), epoxy, acrylic-based resin, silicone, polyimide polymer, or combinations of the above, but are not limited thereto. Inorganic insulating materials include, for example, silicon oxide or silicon nitride, but are not limited thereto. The insulating layer 125 may have an aperture A125a and an aperture A125b. The aperture A125a exposes the partial first electrode 123, and the aperture A125b exposes the partial reflective layer 122.

The first contact pad 126 and the second contact pad 127 are disposed on the same side of the light-emitting diode 120 (e.g., in FIG. 1B, the first contact pad 126 and the second contact pad 127 are both disposed on the lower side of the light-emitting diode 120). The first contact pad 126 is electrically connected to the first-type semiconductor layer SL1 of the light-emitting diode 120, and the second contact pad 127 is electrically connected to the second-type semiconductor layer SL2 of the light-emitting diode 120.

In detail, the first contact pad 126 is disposed on the insulating layer 125 and located in the aperture A125a, and the first contact pad 126 is electrically connected to the first electrode 123 through the aperture A125a, and the first contact pad 126 can be electrically connected to the first-type semiconductor layer SL1 of the light-emitting diode 120 through the first electrode 123. In addition, the first pad 100 of the circuit substrate 10 can be electrically connected to the first electrode 123 through the first contact pad 126. The material of the first contact pad 126 includes, for example, gold, tin, indium, copper, or other suitable conductive materials.

The second contact pad 127 is disposed on the insulating layer 125 and located in the aperture A125b, the second contact pad 127 is electrically connected to the reflective layer 122 through the aperture A125b, and the second contact pad 127 can be electrically connected to the second-type semiconductor layer SL2 of the light-emitting diode 120 through the reflective layer 122 and the second electrode 124. From another perspective, the second electrode 124 (e.g., also called a transparent conductive layer) disposed on the light-emitting diode 120 is electrically connected to the second contact pad 127 through the reflective layer 122. In some embodiments, as shown in FIG. 1B, the second contact pad 127 may surround the first contact pad 126, but is not limited thereto. In addition, the second pad 102 of the circuit substrate 10 can be electrically connected to the second electrode 124 through the second contact pad 127 and the reflective layer 122.

By adopting a vertical light-emitting diode structure, the size (e.g., area) of the light-emitting diode 120 may be reduced and the problem of uneven lateral current distribution may be improved, thereby reducing costs and/or improving luminous efficiency. In addition, the light extraction efficiency may be improved by forming the reflective layer 122 on the side surface S121 of the filling layer 121. In addition, by disposing the first contact pad 126 and the second contact pad 127 on the same side (e.g., the lower side) of the light-emitting chip 12, it is easier to monitor the yield of the light-emitting chip 12 after transfer, and it is possible to bond the light-emitting chip 12 to the circuit substrate 10 in a way that is more efficient in terms of transfer (e.g., in terms of fluid transfer).

The underfill layer 13 is disposed in the aperture A11 of the pixel definition layer 11. In addition to being disposed between the light-emitting chip 12 and the pixel definition layer 11, the underfill layer 13 can also be disposed between the light-emitting chip 12 and the circuit substrate 10. The underfill layer 13 can improve the adhesion between the light-emitting chip 12 and the circuit substrate 10. The material of the underfill layer 13 can be referred to the material of the filling layer 121, and therefore will not be repeated in the following.

According to different requirements, the display device 1 may optionally include other components or film layers. Taking FIG. 1A as an example, the display device 1 may also include a color conversion layer 14. The color conversion layer 14 is disposed on the light-emitting chip 12. By replacing the multi-color light-emitting chip with a single-color light-emitting chip 12 and the color conversion layer 14, the complexity of the transfer process may be reduced, the cost may be reduced, and/or the color performance may be improved. For example, the color conversion layer 14 can include a red conversion layer 140, a green conversion layer 142, and a light scattering layer 144. The red conversion layer 140, the green conversion layer 142, and the light scattering layer 144 are respectively disposed in multiple apertures A11 and overlapped with multiple light-emitting chips 12 respectively. The red conversion layer 140 can, for example, convert the blue light emitted by the light-emitting chip 12 into red light. The green conversion layer 142 can, for example, convert the blue light emitted by the light-emitting chip 12 into green light. The light scattering layer 144 can, for example, diffuse or scatter the blue light emitted by the light-emitting chip 12. The materials of the red conversion layer 140 and the green conversion layer 142 include, for example, fluorescence, phosphor, quantum dot (QD), or other materials that can convert short-wavelength light into long-wavelength light. The light-scattering layer 144 may include a light-transmitting layer and multiple light-scattering particles dispersed in the light-transmitting layer. The light-scattering particles may include, for example, titanium dioxide, but are not limited thereto.

In some embodiments, as shown in FIG. 1A, the display device 1 may further include a color filter layer 15. The color filter layer 15 is disposed on the color conversion layer 14. Through the arrangement of the color filter layer 15, the color purity may be improved. For example, the color filter layer 15 may include a red filter layer 150, a green filter layer 152, and a blue filter layer 154. The red filter layer 150, the green filter layer 152, and the blue filter layer 154 are respectively disposed in multiple apertures A11 and overlap with the red conversion layer 140, the green conversion layer 142, and the scattering layer 144, respectively. The red filter layer 150 can, for example, allow red light to pass through and filter other color light. The green filter layer 152 can, for example, allow green light to pass through and filter other color light. The blue filter layer 154 can, for example, allow blue light to pass through and filter other color light.

In some embodiments, as shown in FIG. 1A, the display device 1 may further include a passivation layer 16. The passivation layer 16 is located between the color conversion layer 14 and the color filter layer 15. For example, the passivation layer 16 can be disposed on the pixel definition layer 11 and extend into the apertures A11 to cover the red conversion layer 140, the green conversion layer 142, and the light scattering layer 144 located in the apertures A11. The passivation layer 16 can be used to protect the color conversion layer 14, for example, to block the adverse effects of moisture and/or oxygen on the color conversion layer 14. The material of the passivation layer 16 includes, for example, silicon oxide, silicon nitride, silicon oxynitride, or a mixture of the foregoing materials, but is not limited thereto.

In some embodiments, as shown in FIG. 1A, the display device 1 may further include a light-shielding layer 17. The light-shielding layer 17 is disposed on the pixel definition layer 11 and includes an aperture A17. The aperture A17 of the light-shielding layer 17 overlaps the aperture A11 of the pixel definition layer 11. The light-shielding layer 17 can be used to absorb stray light and reduce mutual interference (e.g., light mixing) between adjacent pixel regions. The material of the light-shielding layer 17 may include opaque organic polymer materials. The opaque organic polymer material may be a white, gray, or black organic polymer material, such as a black matrix, but is not limited thereto. The aperture A17 of the light-shielding layer 17 is used to allow light to pass through, so that the light emitted from the color filter layer 15 can pass through the light-shielding layer 17 and be output from the display device 1.

In some embodiments, as shown in FIG. 1A, the display device 1 may also include a transparent material 18. The transparent material 18 is disposed in the aperture A17 of the light-shielding layer 17. The transparent material 18 can be used to fill the aperture A17 of the light-shielding layer 17 and reduce the loss of light when propagating through the transparent material 18. The transparent material 18 includes, for example, acrylic materials, siloxane materials, photoresist, silicone, or other materials with a transmittance of visible light greater than 80% or even 90%. In some embodiments, the refractive index of the transparent material 18 may be greater than 1 and less than 1.5.

In some embodiments, as shown in FIG. 1A, the display device 1 may also include a microlens 19. The microlens 19 is provided on the transparent material 18. The microlens 19 can be used to collimate the light, thereby increasing the brightness of the light. The material of the microlens 19 may include acrylic materials, photoresist, or other light-transmitting materials with a refractive index approximately equal to 1.5. In some embodiments, as shown in FIG. 1A, the microlens 19 can be disposed on the transparent material 18 and the light-shielding layer 17, and a top surface T18 of the transparent material 18 and a top surface T17 of the light-shielding layer 17 can be flush to provide a flat surface for carrying the microlens 19.

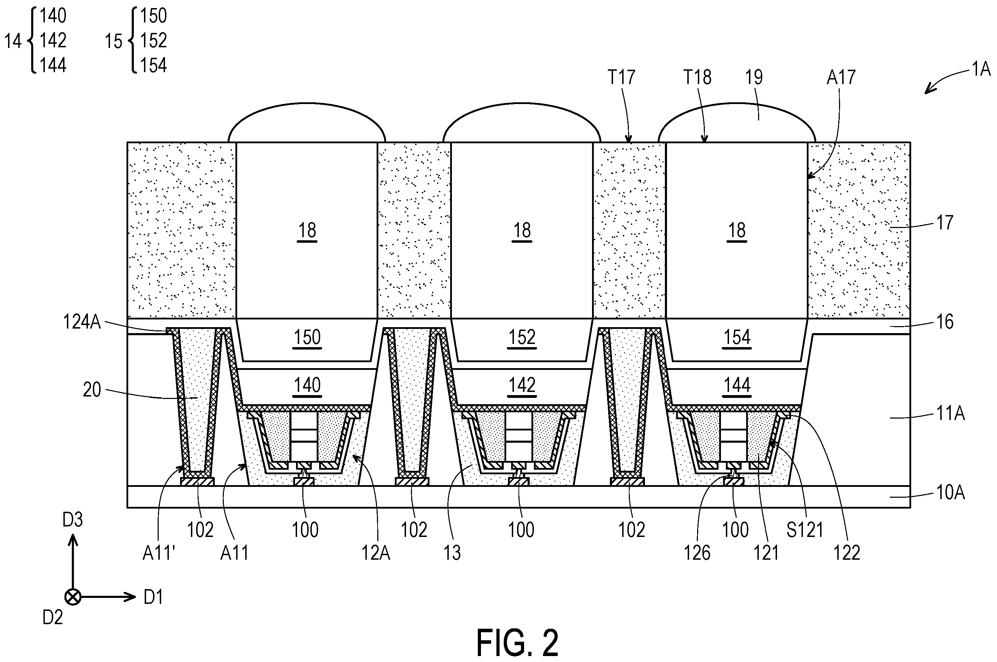

Please refer to FIG. 2. The main differences between a display device 1A and the display device 1 in FIG. 1A are explained below. In the display device 1A, the first pad 100 of a circuit substrate 10A is located in the aperture A11, and the second pad 102 is not located in the aperture A11. Specifically, the second pad 102 is located on one side of the first pad 100, for example, and a pixel definition layer 11A also includes another aperture (e.g., an aperture A11'). The aperture A11' exposes the pad (e.g., the second pad 102) of the circuit substrate 10A, and a second electrode 124A (e.g., also called a transparent conductive layer) of a light-emitting chip 12A electrically connects the pad (e.g., the second pad 102) to the light-emitting diode 120 (marked in FIG. 1B).

Specifically, the aperture A11' overlaps the second pad 102 in the direction D3 and, for example, partially exposes the second pad 102. The second electrode 124A of the light-emitting chip 12A extends, for example, from a second semiconductor layer SL2 of the light-emitting diode 120 to the underfill layer 13 and the pixel definition layer 11A, and extends into the aperture A11' to electrically connect with the second pad 102. In some embodiments, as shown in FIG. 2, the display device 1A may further include a filling layer 20. The filling layer 20 can fill the space in the aperture A11' not occupied by the second electrode 124A, but is not limited thereto. The material of filling layer 20 can be referred to the material of the underfill layer 13, and therefore will not be repeated in the following.

By adopting a vertical light-emitting diode structure, the size (e.g., area) of the light-emitting diode 120 may be reduced and the problem of uneven lateral current distribution may be improved, thereby reducing costs and/or improving luminous efficiency. In addition, the light extraction efficiency may be improved by forming the reflective layer 122 on the side surface S121 of the filling layer 121. In addition, the light-emitting chip 12A can be bonded to the circuit substrate 10A using a method with higher transfer efficiency (for example, fluid transfer). Furthermore, by replacing the multi-color light-emitting chip with a single-color light-emitting chip 12A and the color conversion layer 14, the complexity of the transfer process may be reduced, the cost may be reduced, and/or the color performance may be improved.

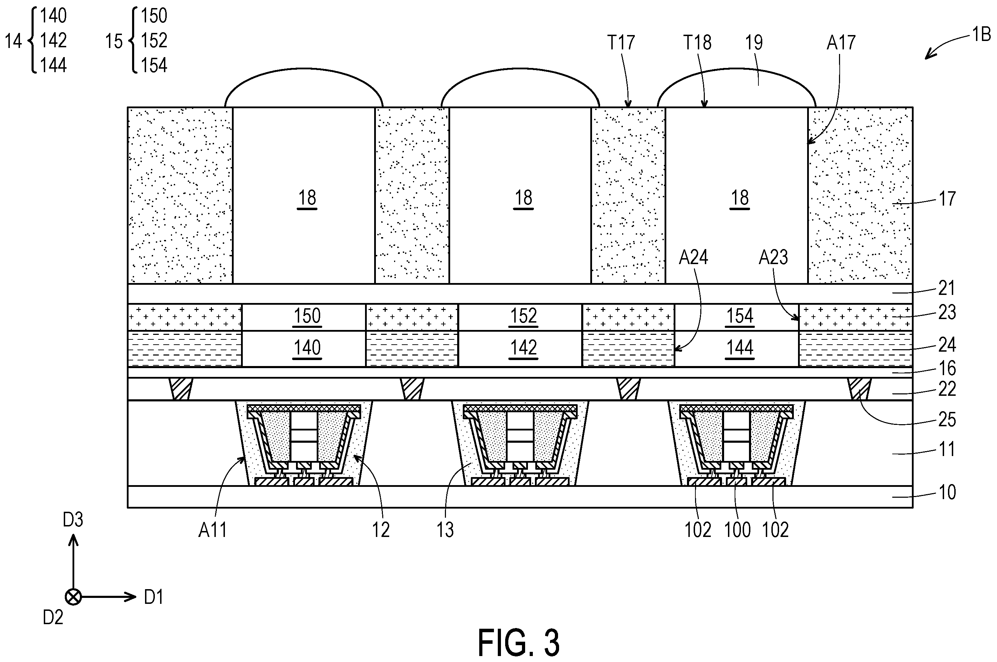

Please refer to FIG. 3. The main differences between a display device 1B and the display device 1 in FIG. 1A are as follows. In the display device 1, the color conversion layer 14 and the color filter layer 15 are disposed in the aperture A11 of the pixel definition layer 11, while in the display device 1B, the color conversion layer 14 and the color filter layer 15 are not disposed in the aperture A11 of the pixel definition layer 11. Specifically, the display device 1B also includes an opposite substrate 21 and an adhesive layer 22. The opposite substrate 21 is disposed opposite to the circuit substrate 10, and the adhesive layer 22 is disposed between the opposite substrate 21 and the circuit substrate 10. In addition, the color conversion layer 14 and the color filter layer 15 are disposed between the adhesive layer 22 and the opposite substrate 21.

In detail, the color conversion layer 14 and the color filter layer 15 can be disposed on a surface of the opposite substrate 21 facing the circuit substrate 10, and the opposite substrate 21 can be bonded to the circuit substrate 10 through the adhesive layer 22. The opposite substrate 21 may be a rigid substrate or a flexible substrate. The material of the opposite substrate 21 includes, for example, glass, quartz, ceramic, sapphire, or plastic, but is not limited thereto. Plastics may include polycarbonate (PC), polyimide (PI), polypropylene (PP), polyethylene terephthalate (PET), and other suitable flexible materials, or combinations of the aforementioned materials, but is not limited thereto. The adhesive layer 22 may include optical clear adhesive (OCA) or optical clear resin (OCR), but is not limited thereto.

In some embodiments, as shown in FIG. 3, the display device 1B may also include a black matrix layer 23 and a bank layer 24. The color conversion layer 14 and the color filter layer 15 are respectively disposed in an aperture A24 of the bank layer 24 and an aperture A23 of the black matrix layer 23. The material of the bank layer 24 can be referred to the material of the pixel definition layer 11, and therefore will not be repeated in the following.

In some embodiments, as shown in FIG. 3, the display device 1B may also include a spacer 25. The spacer 25 is disposed between the bank layer 24 and the pixel definition layer 11. In an embodiment in which the display device 1B further includes a passivation layer 16, the passivation layer 16 is disposed on a surface of the color conversion layer 14 away from the color filter layer 15, and the passivation layer 16 can further cover a surface of the bank layer 24 away from the black matrix layer. 23. In this design, the spacer 25 is disposed between the passivation layer 16 and the pixel definition layer 11, for example.

By fabricating the color conversion layer 14 and the color filter layer 15 on the opposite substrate 21 and then bonding them to the circuit substrate 10, it helps to reduce the process difficulty or reduce the thickness of the pixel definition layer 11.

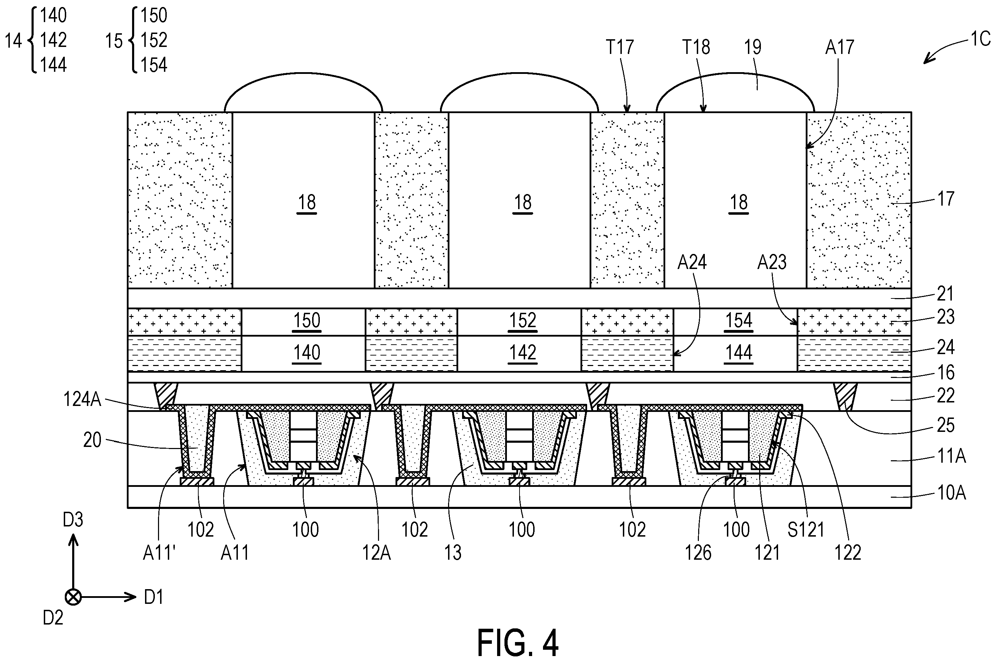

Please refer to FIG. 4. The main differences between a display device 1C and the display device 1A in FIG. 2 are explained below. In the display device 1A, the color conversion layer 14 and the color filter layer 15 are disposed in the aperture A11 of the pixel definition layer 11A, while in the display device 1C, the color conversion layer 14 and the color filter layer 15 are not disposed in the aperture A11 of the pixel definition layer 11A. As modified in FIG. 3, the display device 1C may also further include an opposite substrate 21, an adhesive layer 22, a black matrix layer 23, a bank layer 24, and a spacer 25. The details about the opposite substrate 21, the adhesive layer 22, the black matrix layer 23, the bank layer 24, and the spacer 25 may be referred to the above, and therefore will not be repeated in the following.

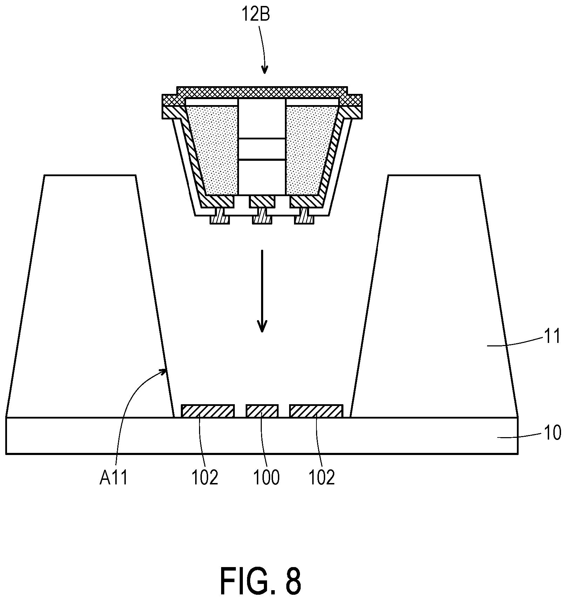

FIG. 5 to FIG. 7 illustrate one of the manufacturing processes of the light-emitting chip, and FIG. 8 to FIG. 9 illustrate one of the processes of the light-emitting chip. However, it should be understood that the manufacturing and/or transfer processes of the light-emitting chip are not limited to those shown in FIG. 5 to FIG. 9.

Referring to FIG. 5, the manufacturing process of the light-emitting chip may include transferring at least one light-emitting diode 120 among multiple light-emitting diodes 120 disposed on a substrate SUB to a transfer substrate SUB1. For example, the substrate SUB may include a wafer or a carrier board, and the method of transferring the light-emitting diode 120 may include stamp transfer, but is not limited thereto. In some embodiments, before transferring the light-emitting diode 120, a sacrificial layer SC1 with adhesive properties may be optionally formed on the transfer substrate SUB1 to enhance the adhesion between the transferred light-emitting diode 120 and the transfer substrate SUB1. The sacrificial layer SC1 may be formed of a material that loses its viscosity under specific conditions (such as heating or illumination) to facilitate the subsequent transfer process. In transferring the light-emitting diode 120 to the transfer substrate SUB1 using stamp transfer, the light-emitting diode 120 may be partially embedded in the sacrificial layer SC1 as shown in FIG. 5, but not limited thereto.

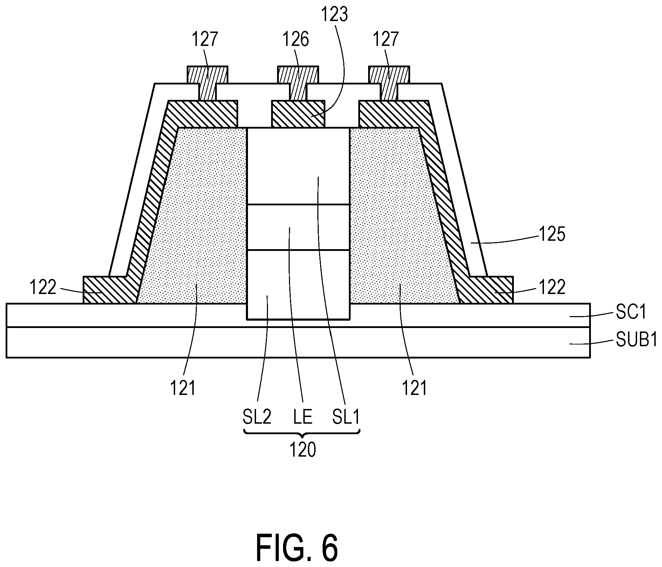

Referring to FIG. 6, the manufacturing process of the light-emitting chip may also include forming a filling layer 121, a reflective layer 122, a first electrode 123, an insulating layer 125, a first contact pad 126, and a second contact pad 127 on the transfer substrate SUB1. The relevant content of the above components and/or film layers can be referred to the above, and therefore will not be repeated in the following.

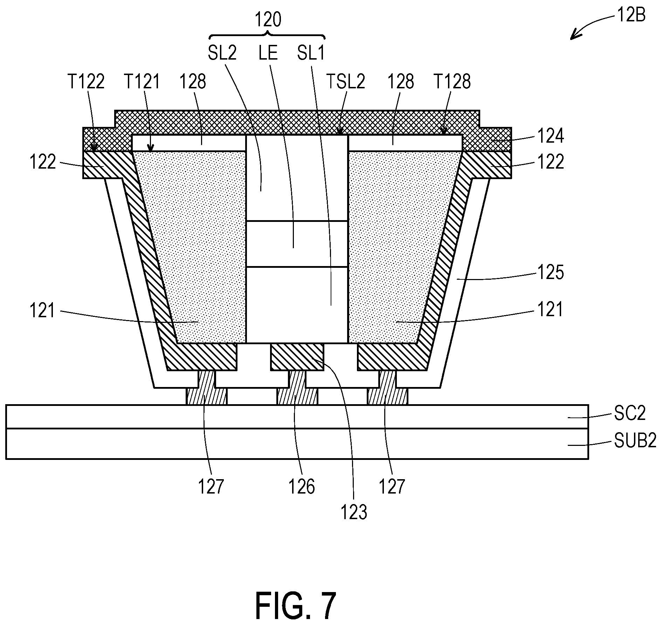

Referring to FIG. 7, the manufacturing process of the light-emitting chip may also include separating the structure shown in FIG. 6 from the transfer substrate SUB1 and transferring the separated structure to a transfer substrate SUB2 in an inverted orientation. For example, the viscosity of the sacrificial layer SC1 may be reduced by heating or illuminating the sacrificial layer SC1, so that the structure shown in FIG. 6 can be separated from the transfer substrate SUB1. In some embodiments, before transferring the structure, an adhesive sacrificial layer SC2 may be optionally formed on the transfer substrate SUB2 to enhance the adhesion between the transferred structure and the transfer substrate SUB2. The sacrificial layer SC2 may be formed of a material that loses its viscosity under specific conditions (such as heating or illumination) to facilitate the subsequent transfer process. After transferring the structure to the transfer substrate SUB2, the structure is inverted, thereby exposing the top surface TSL2 of the second-type semiconductor layer SL2, the top surface T121 of the filling layer 121, and the top surface T122 of the reflective layer 122.

In some embodiments, a dielectric layer 128 may be formed on the top surface T121 of the filling layer 121. A top surface T128 of the dielectric layer 128 is, for example, flush with the top surface TSL2 of the second-type semiconductor layer SL2 to provide a flat surface carrying the second electrode 124. The dielectric layer 128 exposes at least part of the top surface T122 of the reflective layer 122 so that the second electrode 124 can be electrically connected to the reflective layer 122. The material of the dielectric layer 128 may include organic insulating materials, inorganic insulating materials, or combinations thereof. Organic insulating materials include, for example, polymethylmethacrylate (PMMA), epoxy, acrylic-based resin, silicone, polyimide polymer, or combinations of the above, but are not limited thereto. Inorganic insulating materials include, for example, silicon oxide or silicon nitride, but are not limited thereto. After the second electrode 124 is formed, the production of a light-emitting chip 12B is initially completed.

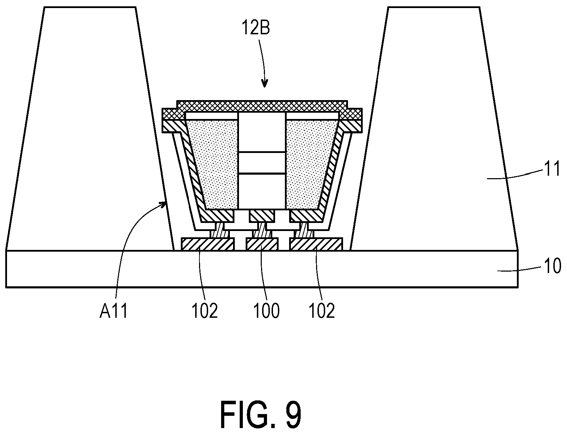

Referring to FIG. 8 and FIG. 9, the transfer process of the light-emitting chip may include separating the light-emitting chip 12B from the transfer substrate SUB2 and transferring the separated light-emitting chip 12B to the circuit substrate 10 and electrically connecting it to the circuit substrate 10. For example, the light-emitting chip 12B can be transferred to the circuit substrate 10 through fluid transfer. During fluid transfer, the light-emitting chip 12B may be flowed in the fluid in a manner in which the contact pad is underneath and the second electrode 124 is on top by disposing a column structure (not shown) on the second electrode 124. By utilizing the wide top and narrow bottom design of the light-emitting chip 12B with the narrow bottom and wide top aperture design of the pixel definition layer 11 (refer to the aperture A11), the success rate of bonding the light-emitting chip 12B to the circuit board 10 may be enhanced. The transfer efficiency may be improved by adopting a more efficient transfer method for bonding the light-emitting chip 12B to the circuit substrate 10. After the light-emitting chip 12B is bonded to the circuit substrate 10, the color conversion layer 14 and the color filter layer 15 can be formed successively (refer to FIG. 1A to FIG. 4). By replacing the multi-color light-emitting chip with a single-color light-emitting chip 12B (e.g., the blue light-emitting chip) and the color conversion layer 14, the complexity of the transfer process may be reduced, the cost may be reduced, and/or the color performance may be improved

In summary, in the embodiments of the disclosure, by adopting a vertical light-emitting diode structure, the size (e.g., area) of the light-emitting diode may be reduced and the problem of uneven lateral current distribution may be improved, thereby reducing costs and/or improving luminous efficiency. In addition, the light extraction efficiency may be improved by forming the reflective layer on the side surface of the filling layer 121. In some embodiments, the light-emitting chip can be bonded to the circuit substrate using a method with higher transfer efficiency. In some embodiments, by replacing the multi-color light-emitting chip with a single-color light-emitting chip and the color conversion layer, the complexity of the transfer process may be reduced, the cost may be reduced, and/or the color performance may be improved.

The above embodiments are only used to illustrate the technical solution of the disclosure, but not to limit it; although the disclosure has been described in detail with reference to the foregoing embodiments, those of ordinary skill in the art should understand that they can still modify the technical solutions recorded in the foregoing embodiments, or make equivalent substitutions for some or all of the technical features. However, these modifications or substitutions do not cause the essence of the corresponding technical solution to deviate from the scope of the technical solution of each embodiment of the disclosure.

Although the embodiments and advantages of the disclosure have been disclosed above, it should be understood that anyone with ordinary skill in the art can make changes, substitutions and modifications without departing from the spirit and scope of the disclosure. Furthermore, the features of various embodiments can be mixed and replaced at will to form other new embodiments. In addition, the protection scope of the disclosure is not limited to the processes, machines, manufacturing, material compositions, devices, methods and steps in the specific embodiments described in the specification. Any process, machine, manufacture, material compositions, device, method, and steps, now or hereafter developed, which may be understood from this disclosure by any person having ordinary knowledge in the art, may be used in accordance with this disclosure, provided that substantially the same function can be performed, or substantially the same result can be obtained, in the embodiments described herein. Accordingly, the scope of protection of the disclosure includes the processes, machines, manufacturing, material compositions, devices, methods, and steps described above. In addition, each claim constitutes an individual embodiment, and the scope of protection of the disclosure also includes a combination of the claims and embodiments. The scope of protection of the disclosure shall be as defined in the scope of the patent application attached hereto.

Anyone with ordinary knowledge in the relevant technical field can learn from the disclosure It is understood that processes, machines, manufacturing, material compositions, devices, methods and steps currently or developed in the future can be used according to the present disclosure as long as they can perform substantially the same functions or obtain substantially the same results in the embodiments described herein. Therefore, the protection scope of the present disclosure includes the above-mentioned processes, machines, manufacturing, material compositions, devices, methods and steps. In addition, each claim constitutes an individual embodiment, and the protection scope of the present disclosure also includes combinations of each claim and embodiment. The scope of protection of this disclosure shall be determined by the scope of the accompanying patent application.

## Claims

1. A display device (1, 1A, 1B, 1C), comprising:
a circuit substrate (10, 10A);
a pixel definition layer (11, 11A), disposed on the circuit substrate and comprising an aperture (A11);
a light-emitting chip (12, 12A, 12B), disposed in the aperture (A11) and electrically connected to the circuit substrate (10, 10A), wherein the light-emitting chip (12, 12A, 12B) comprises a light-emitting diode (120), a filling layer (121), and a reflective layer (122), the filling layer (121) surrounds the light-emitting diode (120), and the reflective layer (122) is disposed on a side surface (S121) of the filling layer (121); and
an underfill layer (13), disposed between the light-emitting chip (12, 12A, 12B) and the pixel definition layer (11, 11A).

2. The display device (1, 1A, 1B, 1C) according to claim 1, further comprising:
a color conversion layer (14), disposed on the light-emitting chip (12, 12A, 12B).

3. The display device (1, 1A, 1B, 1C) according to claim 2, further comprising:
a color filter layer (15), disposed on the color conversion layer (14).

4. The display device (1B, 1C) according to claim 3, further comprising:
an opposite substrate (21), disposed opposite to the circuit substrate (10, 10A); and
an adhesive layer (22), disposed between the opposite substrate (21) and the circuit substrate (10, 10A).

5. The display device (1B, 1C) according to claim 4, wherein the color conversion layer (14) and the color filter layer (15) are disposed between the adhesive layer (22) and the opposite substrate (21).

6. The display device (1B, 1C) according to any of claims 4 and 5, further comprising:
a black matrix layer (23); and
a bank layer (24), wherein the color conversion layer (14) and the color filter layer (15) are disposed in an aperture (A24) of the bank layer (24) and an aperture (A23) of the black matrix layer (23) respectively.

7. The display device (1B, 1C) according to claim 6, further comprising:
a spacer (25), disposed between the bank layer (24) and the pixel definition layer (11, 11A).

8. The display device (1, 1A) according to claim 3, wherein the color conversion layer (14) and the color filter layer (15) are disposed in the aperture (A11) of the pixel definition layer (11, 11A).

9. The display device (1, 1A, 1B, 1C) according to any of claims 1 to 8, further comprising:
a light-shielding layer (17), disposed on the pixel definition layer (11, 11A) and comprising an aperture (A17), wherein the aperture (A17) of the light-shielding layer (17) overlaps the aperture (A11) of the pixel definition layer (11, 11A).

10. The display device (1, 1A, 1B, 1C) according to claim 9, further comprising:
a transparent material (18), disposed in the aperture (A17) of the light-shielding layer (17).

11. The display device (1, 1A, 1B, 1C) according to claim 10, further comprising:
a microlens (19), disposed on the transparent material (18).

12. The display device (1, 1B) according to any of claims 1 to 11, wherein the light-emitting chip (12, 12B) further comprises a first contact pad (126) and a second contact pad (127), the first contact pad (126) and the second contact pad (127) are disposed on a same side of the light-emitting diode (120), the first contact pad (126) is electrically connected to a first-type semiconductor layer (SL1) of the light-emitting diode (120), and the second contact pad (127) is electrically connected to a second-type semiconductor layer (SL2) of the light-emitting diode (120).

13. The display device (1, 1B) according to claim 12, wherein the light-emitting chip (12, 12B) further comprises a transparent conductive layer (124), the transparent conductive layer (124) is disposed on the light-emitting diode (120) and electrically connected to the second contact pad (127) through the reflective layer (122).

14. The display device (1, 1B) according to claim 13, wherein the transparent conductive layer (124) is also disposed on the filling layer(121) and the reflective layer (122).

15. The display device (1A, 1C) according to any of claims 1 to 11, wherein the pixel definition layer (11A) further comprises another aperture (A11') exposing a pad (102) of the circuit substrate (10A), and the light-emitting chip (12A) further comprises a transparent conductive layer (124A) electrically connecting the pad (102) to the light-emitting diode (120).
